# EUROPEAN PATENT APPLICATION

(11) **EP 4 636 766 A2**
(43) Date of publication of application: **22.10.2025**
(21) Application number: 25171313.7
(22) Date of filing: 17.04.2025
(51) Int. Cl.: G11C 11/16

(54) **SENSING STANDALONE MTJ WITHOUT BIAS**

(30) Priority: 18.04.2024 US 202463635852 P; 16.04.2025 US 202519180918
(71) Applicant: Everspin Technologies, Inc., Chandler, Arizona 85226 (US)
(72) Inventor: WILLIAMS, Jacob T., Chandler, AZ, 85226 (US); ALAM, Syed M., Chandler, AZ, 85226 (US); SADD, Michael A., Chandler, AZ, 85226 (US); GOGL, Dietmar, Chandler, AZ, 85226 (US); DO, Vincent, Chandler, AZ, 85226 (US); HUTCHISON, Brian, Chandler, AZ, 85226 (US)
(74) Representative: Eisenführ Speiser

(57) **Abstract**

A memory device includes a magnetic tunnel junction (MTJ) array having a logical state and a capacitive net charged to a first voltage and electrically connected to the MTJ array. The memory device further includes a read device electrically connected to the MTJ array and configured to read the logical state of the MTJ array as the capacitive net discharges to a second voltage different than the first voltage.

## Description

### CROSS-REFERENCE TO RELATED APPLICATION

This application claims benefit to U.S. Provisional Patent Application No. 63/635,852 filed April 18, 2024, the entire contents of which are incorporated herein by reference.

### TECHNICAL FIELD

The present disclosure relates generally to systems and methods for a memory device, and, more particularly, reading memory devices without biasing.

### INTRODUCTION

Each integrated circuit chip may include billions of devices thereon, including memory devices such as magnetoresistive tunnel junctions (MTJs). However, MTJs may experience defects during the manufacturing process, or may experience damage throughout the lifetime of the device, that may adversely affect the operation of a memory device. Defects or damage may include, for example, short or open defects. A short defect causes unintentional electrical contact between layers of an MTJ (e.g., the MTJ may constantly conduct electrical current), while an open defect causes an MTJ to act as an open switch (e.g., no electrical conduction therein). Both short and open defects can adversely affect or destroy MTJ performance. Therefore, it is desirable to have a memory device that is tolerant of defects and damage. Furthermore, it is desirable to achieve such a memory device in a manner that does not require any peripheral bias circuitry, serves as replacement for a digital flip flop, and can be placed anywhere on an integrated circuit.

### BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts an exemplary circuit schematic of a memory device including a read device for sensing an MTJ array without biasing, according to one or more embodiments.
FIG. 2 depicts an exemplary graph illustrating a voltage applied over time in the memory device of FIG. 1, according to one or more embodiments.
FIGS. 3A, 3B, 3C, and 3D depict exemplary MTJ arrangements within the memory device of FIG. 1, according to one or more embodiments.
FIG. 4 depicts an exemplary block diagram of a memory device, according to one or more embodiments.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In the interest of conciseness, conventional techniques, structures, and principles known by those skilled in the art may not be described herein, including, for example, standard magnetoresistive random access memory (MRAM) process techniques, generation of bias voltages, fundamental principles of magnetism, and basic operational principles of memory devices.

For the sake of brevity, conventional techniques related to accessing (e.g., reading or writing) memory, and other functional aspects of certain systems and subsystems (and the individual operating components thereof) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in an embodiment of the subject matter.

The magnetic tunnel junction (MTJ) is a fundamental unit of a memory array and may include, among other things, two magnetic layers on opposite sides of an insulator. The two magnetic layers may include a fixed magnetic layer (also known as the reference layer) with a fixed magnetic moment and a free layer with a non-fixed magnetic moment. By changing the direction of the magnetic moment of the free layer, the logical state of the MTJ may be changed (also known as "programming" or "writing" the MTJ). The two separate states exhibit different resistance magnitudes. Generally, when the fixed and free layer have a parallel magnetic orientation, the resistance is lower than when the free layer is anti-parallel to the fixed layer. This resistance change can be used to sense and distinguish the two resistance states into a logical state.

An MTJ bit, such as a configuration bit, may include multiple MTJs that may be electrically connected together. The logical state of the MTJ bit may be based on the differences in polarities of the individual MTJs in an MTJ bit. An MTJ bit may be electrically connected to a read device, which reads the logical state of the MTJ bit based on comparisons of the relative magnetic polarities between sets of MTJs in the MTJ bit. Based on the results of that comparison, the read device will read (or "sense") a logical state corresponding to the logical state of the MTJ bit.

Embodiments of this disclosure relate to reading (or "sensing") the state of a resistive memory without the use of any bias circuitry, which enables a non-volatile flop. Embodiments of this disclosure further provide a memory device that may serve as a standalone bitcell that could be placed anywhere on an integrated circuit chip and enables a non-volatile flip flop. For example, a memory device including non-volatile flip flop circuitry (such as, e.g., the ones described in U.S. Patent Application Number 18/478,643, which is incorporated herein by reference in its entirety) mitigates the control of, e.g., signal routing challenges, by including a scan chain serial interface that enables distribution of one or more shared control signals amongst a plurality of non-volatile bits that may be grouped together in a chip. Specifically, distribution of one or more shared control signals may be achieved using various logic circuitries such as flip-flops and latches, which may facilitate execution of various read or write operations for the plurality of non-volatile bits based on different phases of a clock signal.

Embodiments of the present disclosure may also include the following aspects. By combining multiple MTJs in series, parallel, or a combination thereof in an MTJ bit (e.g., a configuration bit), the array of MTJs in the MTJ bit may create certain tolerances to a single MTJ defect. For example, when sensing a single MTJ as either 0 or 1, a defect may be detected due to a short, open, or other defect. However, when an MTJ bit includes an array (e.g., two, four, or eight MTJs) or MTJs arranged in series, parallel, or a combination thereof, even when a defect is detected in one of the MTJs in the array, the defect would not affect the result of the reading operation. In addition, using a latch structure (e.g., strong arm latch) without any complex timing sequences may allow for seamlessly sensing differences in MTJs states.

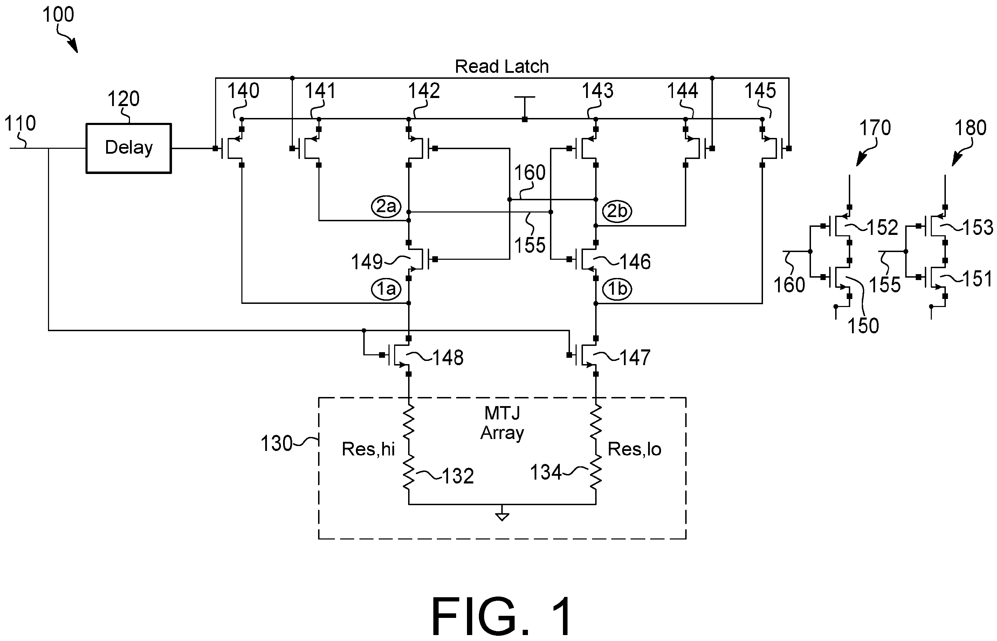

FIG. 1 illustrates an exemplary circuit schematic of a memory device including a read device for sensing an MTJ array without biasing, according to one or more embodiments. The schematic may show a memory device including a read device (e.g., read latch such as, for example, a strong arm latch) electrically connected to an MTJ array having a logical state (e.g., 1 or 0). A read device may read or sense the written logical state of the MTJ array by comparing the resistances of two sets of MTJs within the MTJ array. The read device may include, e.g., any possible latch, including one with a current-limiting input and a differential current input. As shown in FIG. 1, memory device 100 may optionally include a delay circuit 120. The delay circuit 120 may generate a delay signal configured to temporally alter the read signal 110 (e.g., current) by a predetermined time delay. The time delay may be predefined based on the characteristics of the memory device and/or the application of use. Read signal 110 may be provided as an input to the delay circuit 120 and transistor 148 and transistor 147. As the read signal 110 is provided to the delay circuit 120, the delay circuit 120 may generate a delay signal based on timing requirements described herein. As the read signal 110 is provided to the transistors 147 and 148, a differential resistance is read from the MTJ array 130.

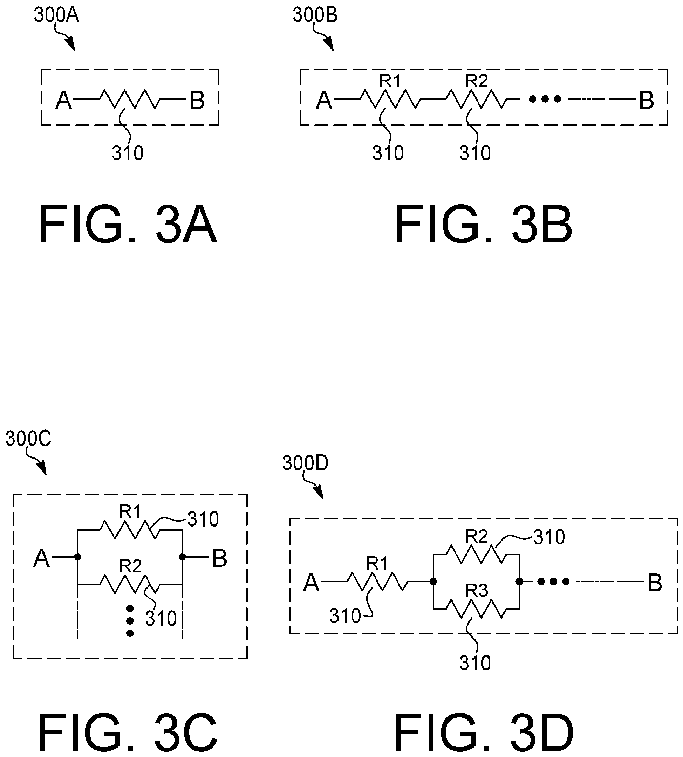

MTJ array 130 may include a first set of one or more MTJs 132 and a second set of one or more MTJs 134. The first set of one or more MTJs 132 may be electrically connected in series, parallel, or a combination thereof. The second set of one or more MTJs 134 may be electrically connected in series, parallel, or a combination thereof. Each of the first and second set of one or more MTJs (e.g., 132 and 134) may be discussed in further detail with respect to FIGS. 3A, 3B, 3C, and 3D. As shown in FIG. 1, the first set of one or more MTJs 132 may be identified as Res,hi indicating a high resistance and the second set of one or more MTJs 134 may be identified as Res,lo indicating a low resistance. Although the first and second set of one or more MTJs (e.g., 132 and 134) are respectively labeled as Res,hi and Res,lo in FIG. 1, the resistance level of each set of one or more MTJs may be arranged in any desired manner (e.g., the first set of one or more MTJs 132 as Res, lo and the second set of one or more MTJs 134 as Res, High, etc.). The topology (e.g., series, parallel, or combination thereof) for each of the first set of one or more MTJs 132 and the second set of one or more MTJs 134 may be the same or different depending on the application of use, timing requirements, or resistance values required. However, when the same topology is used between the first set of one or more MTJs 132 and the second set of one or more MTJs 134, the MTJ array 130 may take advantage of matching the parasitic resistance for each of the first and second set of one or more MTJs. In alternate embodiments, any one of the first and second set of MTJs (e.g., 132 or 134) may be replaced by a fixed or trimmable resistor or resistance implemented with transistors, poly, diffusion, or other types of resistors.

As the read signal 110 is input into transistors 147 and 148, the differential resistance may be determined between the first set of one or more MTJs 132 and the second set of one or more MTJs 134. The differential resistance may be provided to one or more pairs of latch nets (e.g., latch net 1a and latch net 1b and latch net 2a and latch net 2b) through transistors 149 and 146. The Latch nets may also be known as "capacitive nets." A first pair of latch nets may include a first latch net 1a and a second latch net 1b. The first latch net 1a may include transistor 149 which may be electrically connected to transistors 148, 140, and 141. The second latch net 1b may include transistor 146 which may be electrically connected to transistors 147, 144, and 145. A second pair of latch nets may include a third latch net 2a and a fourth latch net 2b. The third latch net 2a may include transistor 142 which may be electrically connected to transistors 141 and 149. The second latch net 2b may include transistor 143 which may be electrically connected to transistors 146 and 144. Each latch net within the pair of latch nets may include, for example, cross-coupled p-type or n-type metal oxide semiconductor transistors (PMOS or NMOS). Each of the transistors described herein may include either PMOS, NMOS, or the like. A limited current may be established based on the differential resistance of the MTJ array 130 while the one or more pairs of latch nets (e.g., 1a/b and 2/b) are pre-charged to VDD (e.g., a supply to voltage rail) when read signal 110 is low (e.g., idle or standby).

Each of the one or more pairs of latch nets may be electrically connected to one another through a first connection 155 and a second connection 160. In addition, each of the one or more pairs of latch nets may be electrically connected to a corresponding inverter (e.g., first inverter 170 and second inverter 180). For example, a first inverter 170 may be electrically connected to the second connection 160 while the second inverter 180 may be electrically connected to the first connection 155. The first inverter 170 may include transistors 150 and 152 and the second inverter 180 may include transistors 151 and 153. The purpose of connecting the first connection 155 and the second connection 160 to individual inverters may be to balance the load for each of the one or more pairs of latch nets. For example, if the second inverter 180 is the output to the outside of the memory device 100, the first inverter 170 may be considered a dummy inverter, where the differential of each inverter may match so that the second inverter 180 may isolate the capacitance outside from the internal nodes (e.g., the one or more pairs of latch nets).

The memory device 100 may charge a capacitance (e.g., a capacitor and/or an implied capacitance of the transistors and connecting metal lines inside the read latch) to a first voltage by supplying current thereto. When a read operation is initiated, for example, when read signal 110 is activated, the memory device 100 may redirect current from the capacitance to the latch devices (e.g., latch nets 1a/b and 2a/b). The capacitance may then begin to discharge due to the current in the MTJ array 130 as the capacitance approaches a second voltage less than the first voltage (e.g., 0V). The two opposing sides of the MTJ array (e.g., 132 and 134) may have different current magnitudes, due to the different resistances of the two sets of MTJs, so the latch nets 1a and 1b may discharge at different rates. The latch structure (e.g., combination of latch nets 1a/b and 2a/b) may then read the logical state of the MTJ array 130 as the capacitance discharges to the second voltage, thereby running current through the MTJ array 130 to the read device. Specifically, the current flows through the first set of MTJs (e.g., 132) having a first resistance greater than a second resistance of the second set of MTJs (e.g., 134). Thus, the current will flow through each set of MTJs differently, based on their respective resistances. Based on the differential current flow through the sets of MTJs, the read device will read the state of the MTJ array 130.

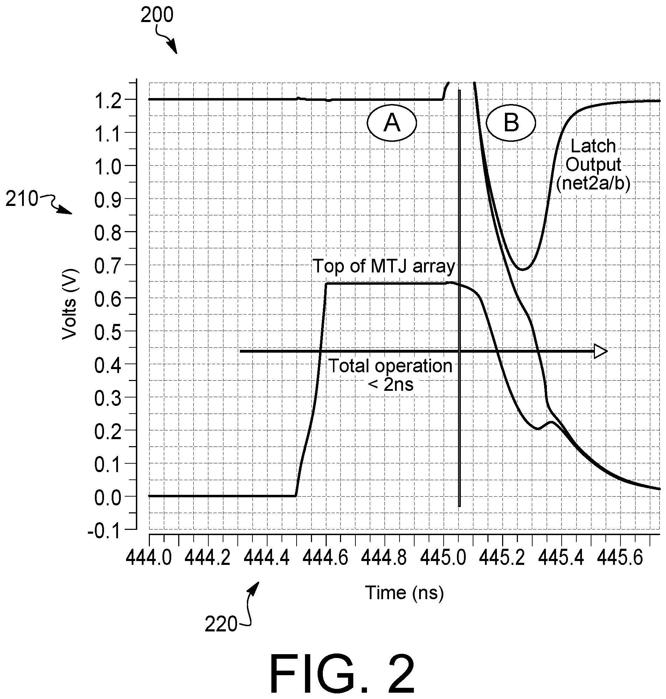

FIG. 2 depicts an exemplary graph illustrating a voltage applied over time in memory device 100 of FIG. 1, according to one or more embodiments. Graph 200 includes a y-axis 210 representing the voltage and an x-axis 220 representing time (e.g., nanoseconds (ns)). Graph 200 illustrates when a read device (e.g., the read latch of the memory device 100) is operative and reads the differential current across the sets of MTJs in the MTJ array (e.g., first set of one or more MTJs 132 and second set of one or more MTJs 134), it may produce an output without significant additional timing. For example, the read device may read the logical state of the MTJ array in approximately less than 2 nanoseconds, as illustrated in graph 200, which shows voltage applied to the latches (e.g., 2a and 2b) and to the MTJ array (from the capacitance) as a function of time after directing the current from the MTJ array to the read circuitry. In graph 200, the line starting at 1.2 V represents the voltage applied to the latches, and the line starting at 0V represents the voltage applied to the MTJ array. Specifically, in the period of time between enabling read signal 110 and the time delay caused by delay circuit 120, the voltage across the MTJ array may be held constant while current is input within the MTJ array but latch nodes 1a, 1b, 2a, and 2b are held high. After the time delay (at the time approximately indicated by the vertical line), latch nodes 1a, 1b, 2a, and 2b may be allowed to respond to the current input redirected from the MTJ to the read device, the voltage across the MTJ array drops from the first voltage to the second voltage (e.g., 0V). The voltage across the latch nets drops quicker than the voltage across the MTJ array drops, however, because the capacitance is slowly discharging current through the MTJ array to the read device, as shown by the difference in steepness in the curves illustrated. Initially all the latch nets discharge. However, when the latch nets discharge enough, one of the transistors (e.g., p-MOS transistors) in the latch turns on. At that point, the logic state within the latch (e.g., the read device) is finally resolved and held therein. The action of resolving states is the initial discharge of the voltage at different rates due to the MTJ current being different in the two resistive MTJ legs, as shown in FIG. 2 with the latch output decreasing at a faster rate than the MTJ array. Through the slow discharge through the MTJ array, the logical state of the MTJ array is read by the latch (e.g., read device). Advantageously, the latch (or read device) only needs 2 timing phases than can be, e.g., the positive and negative phase of a single clock or derived from one edge using a simple delay circuit. Further, the latch conducts zero current when idle before and after the read operation. MTJs only conduct current until the latch resolves, which minimizes read disturb exposure.

FIGS. 3A, 3B, 3C, and 3D illustrate exemplary MTJ arrangements within memory device 100 of FIG. 1, according to one or more embodiments. Each set of MTJs (e.g., first set of one or more MTJs 132 and second set of one or more MTJs 134) in MTJ array 130 shown in FIG. 1 may be arranged in electrical series, parallel, or a combination thereof. FIG. 3A illustrates MTJ set 300A which may include a single MTJ 310 used for each set of MTJs within the MTJ array 130. Each set of MTJs (e.g., each of the first set of one or more MTJs 132 and second set of one or more MTJs 134) within the MTJ array 130 may include a single MTJ 310 as shown in MTJ set 300A.

FIG. 3B illustrates MTJ set 300B which may include two or more MTJs 310 connected in electrical series. MTJ set 300B may be used for each set of MTJs within the MTJ array 130. Each set of MTJs (e.g., each of the first set of one or more MTJs 132 and second set of one or more MTJs 134) within the MTJ array 130 may include two or more MTJs 310 as shown in MTJ set 300B. Having two or more MTJs 310 connected in series in each set of MTJs within the MTJ array 130 may provide the advantage of summing the resistance of each MTJ (e.g., R1 and R2) for the overall resistance of the set of MTJs. This may provide an additional advantage of creating a larger resistance for the MTJ set, which reduces the disturb voltage applied to any one MTJ within an MTJ set and increases the overall resistance difference between the sets of MTJs 132 and 134. Also, if shorted, (e.g., low resistance) MTJs are predisposed to be a dominant fail mode, a series connection of MTJs may mitigate the impact of the fail mode if the remaining (non-shorted) MTJs have a sufficient resistance to overcome the short and sense correctly.

FIG. 3C illustrates MTJ set 300C which may include two or more MTJs 310 connected in electrical parallel. MTJ set 300C may be used for each set of MTJs within the MTJ array 130. Each set of MTJs (e.g., each of the first set of one or more MTJs 132 and second set of one or more MTJs 134) within the MTJ array 130 may include two or more MTJs 310 as shown in MTJ set 300C. Having the two or more MTJs 310 connected in parallel in each set of MTJs within the MTJ array 130 may provide the advantage of avoiding a dominant fail. For example, when multiple MTJs are connected in electrical series, one high resistance MTJ (e.g., open) may permit the series of MTJs to behave as if it is a high resistance open. If open MTJs are predisposed to be a dominant fail mode, connecting the MTJs in series may not be preferred. To avoid these issues, connecting the MTJs in parallel may mitigate the occurrence of an open MTJ in the set of MTJs.

FIG. 3D illustrates MTJ set 300D which may include two or more MTJs 310 connected in electrical series and parallel. MTJ set 300D may be used for each set of MTJs within the MTJ array 130. Each set of MTJs (e.g., each of the first set of one or more MTJs 132 and second set of one or more MTJs 134) within the MTJ array 130 may include two or more MTJs 310 as shown in MTJ set 300D. The combination of series and parallel connections may be used to balance the benefits of these different types of connections, as discussed above in reference to FIGS. 3B-3C. The number of MTJs used in each set of MTJs within the MTJ array 130 may vary based on the application or use, timing requirements, and/or the current available for each write procedure. For example, the more MTJs used within the MTJ array 130, the more current may be required for each set of MTJs and therefore the MTJ array 130.

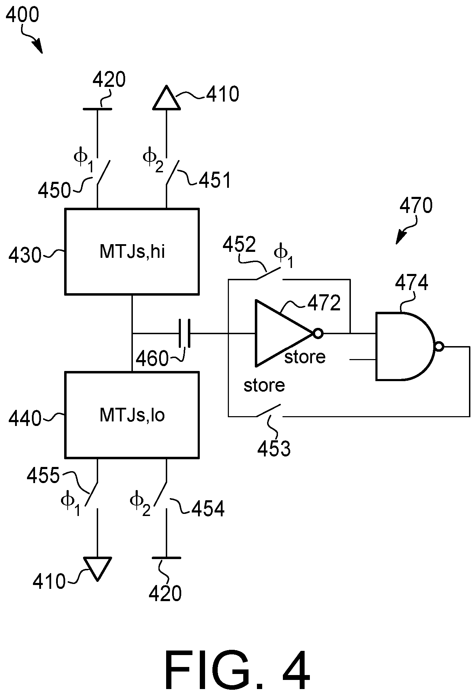

FIG. 4 illustrates an exemplary block diagram of a memory device, according to one or more embodiments. Memory device 400 may include an alternate latching structure, including any possible latch structure. Memory device 400 may be substantially similar to memory device 100 except as described herein. Memory device 400 may differ from the memory device 100 of FIG. 1 based on the inclusion of a bias (e.g., a voltage is applied thereto). Memory device 400 may include VDD 410, ground 420, a first set of one or more MTJs 430, a second set of one or more MTJs 440, and one or more switches (e.g., 450, 451, 454, and 455). Memory device 400 may further include a read device 470 including a capacitor 460, an inverter 472, a NAND gate 474, and one or more switches (e.g., 452 and 453).

Memory device 400 may operate in at least two phases (e.g., Φ1 and Φ2). During phase 1 (e.g., Φ1), switch 450 and switch 455 may be closed while switch 451 and switch 454 may be open, and may establish a voltage across the first set of one or more MTJs 430 and the second set of one or more MTJs 440 while the inverter 472 is held at its trip point by closing switch 452. The first set of one or more MTJs 430 may be a high-resistance MTJ set and the second set of one or more MTJs 440 may be a low-resistance MTJ set. The first set of one or more MTJs 430 may include a first resistance greater than a second resistance of the second set of one or more MTJs 440. The first set of one or more MTJs 430 and the second set of one or more MTJs 440 may be substantially similar to the first set of one or more MTJs 132 and the second set of one or more MTJs 134 described in reference to FIG. 1. During phase 1, a voltage may be established at one side of the capacitor 460 plate equal to the ratio of the resistance of the first set of one or more MTJs 430 (e.g., the high resistance MTJ set) to the total resistance of the two MTJ sets (e.g., 430 and 440) times the value of applied bias 420. The other side of the capacitor 460 may be at the aforementioned trip point of the inverter 472. While at its trip point, the inverter 472 may conduct current related to the size of the inverter 472 devices.

During phase 2 (e.g., Φ2), switch 451 and switch 454 may be closed while switch 450 and switch 455 may be open with the polarity of the voltage applied to the two MTJ sets (e.g., 430 and 440) may be reversed, with a high voltage applied to the second set of one or more MTJs 440 while the first set of one or more MTJs 430 may be electrically connected to ground 420. The inverter 472 input-to-output switch 452 may be also opened. Since the polarity of the MTJ resistance tree may reverse, the capacitor 460 may see a new voltage. This voltage may now be proportional to the ratio of the low resistance state to the total resistance of the two MTJ sets (e.g., 430 and 440) times the value of applied bias 420. This new voltage may force a change in the voltage on the inverter side of the capacitor 460, to maintain charge conservation. The inverter 472 may respond to this voltage change by either discharging, or charging the output based on the direction of the voltage change. In that way, the read device 470 may store a logical state represented by the two MTJ sets (e.g., 430 and 400).

During a final step, the store signal may be asserted by closing switch 453 and asserting high the store input to NAND gate 474. Asserting store may create a reinforcing logical feedback between the inverter 472 and NAND gate 474 that may pull the input of the inverter 472 to either ground 420 or VDD 410, consistent with the output of the inverter 472 after phase 2. The voltage may then be removed across the two MTJ sets (e.g., 430 and 44) so that they may not consume power, while the data is retained by the feedback through the inverter 472 and NAND gate 474.

Another embodiment may include using only one MTJ set (e.g., 430 or 440) for either of MTJs,lo or MTJs,hi. In such an embodiment, the other of MTJs,hi or MTJs,lo may be replaced by a reference resistor network. In such an implementation, the read device 470 may read the logical state of the MTJ array by comparing the current through the first set of MTJs and through the set of resistors. Further, embodiments here describe a no-bias method for sensing, whereas a simplified bias method with a very fast ramp time, for example, a read signal or any other read bias, is also possible as an alternate method.

In one embodiment, the present disclosure is drawn to a magnetic tunnel junction (MTJ) array having a logical state, wherein the MTJ array includes a first set of one or more MTJs and a second set of one or more MTJs; a capacitive net charged to a first voltage and electrically connected to the MTJ array; and a read device electrically connected to the MTJ array and configured to read the logical state of the MTJ array as the capacitive net discharges to a second voltage different than the first voltage.

Various aspects of the present disclosure may also include: wherein the first set of one or more MTJs having a first resistance; and the second set of one or more MTJs having a second resistance different than the first resistance, and wherein the capacitive net discharges a current differentially through the first set of one or more MTJs and the second set of one or more MTJs as the capacitive net discharges to the second voltage; wherein the first set of one or more MTJs are electrically connected in series, in parallel, or in series and in parallel with one another; wherein the second set of one or more MTJs are electrically connected in series, in parallel, or in series and in parallel with one another; wherein the read device includes an inverter; wherein the read device includes a latch; and further including a delay circuit configured to generate a delay signal that temporally alters a read signal provided to the MTJ array.

In another embodiment, the present disclosure is drawn to a memory device, comprising: a read device including an inverter and a capacitor; a magnetic tunnel junction (MTJ) array including: a first set of one or more MTJs with a first resistance; and a second set of one or more MTJs with a second resistance, wherein the first resistance is different than the second resistance, wherein the read device is capacitively connected to the MTJ array, and the read device is configured to read a state of the MTJ array after a voltage across the MTJ array is reversed.

Various aspects of the present disclosure may also include: wherein the capacitor electrically couples the MTJ array to the inverter, and the capacitor changes a switch direction of the inverter; wherein the first set of one or more MTJs are electrically connected in series, in parallel, or in series and in parallel with one another; wherein the second set of one or more MTJs are electrically connected in series, in parallel, or in series and in parallel with one another; wherein the voltage across the MTJ array is dependent on a direction of the voltage across the MTJ array, wherein the first resistance is less than the second resistance or the first resistance is greater than the second resistance; wherein the inverter is configured to assert a store signal creating a reinforcing logical feedback to remove the voltage across the MTJ array; and wherein the first set of one or more MTJs and the second set of one or more MTJs include substantially similar topologies.

In yet another embodiment, the present disclosure is drawn to a method of reading a magnetic tunnel junction (MTJ) device, comprising: during a first phase: applying a first voltage having a first polarity to an **MTJ** network capacitively coupled to an inverter of a reading device, wherein the **MTJ** network includes a first set of one or more **MTJs** and a second set of one or more **MTJs;** and during a second phase: reading a logical state of the **MTJ** network by initiating the inverter in response to a change in the voltage of the **MTJ** network by applying a second voltage having a second polarity opposite the first polarity to the **MTJ** network.

Various aspects of the present disclosure may also include: wherein the first set of one or more **MTJs** includes a first resistance electrically coupled to a second set of one or more **MTJs** including a second resistance different from the first resistance; wherein the first set of one or more **MTJs** are electrically connected in series, in parallel, or a combination thereof; wherein the second set of one or more MTJs are electrically connected in series, in parallel, or in series and in parallel with one another; wherein the reading device includes a latch; and wherein the inverter is configured to assert a store signal creating a reinforcing logical feedback to remove the first voltage and the second voltage across the MTJ network.

Other embodiments of the disclosure will be apparent to those skilled in the art from consideration of the specification and practice of the embodiment(s) disclosed herein. It is intended that the specification and examples may be considered as exemplary only, with a true scope and spirit of the embodiment(s) being indicated by the following claims.

While exemplary embodiments have been presented above, it should be appreciated that many variations exist. Furthermore, while the description includes references to memory cells and devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

The foregoing description of the inventions has been described for purposes of clarity and understanding. It is not intended to limit the inventions to the precise form disclosed. Various modifications may be possible within the scope and equivalence of the application.

## Claims

1. A memory device, comprising:
a magnetic tunnel junction (MTJ) array having a logical state, wherein the MTJ array includes a first set of one or more MTJs and a second set of one or more MTJs;
a capacitive net charged to a first voltage and electrically connected to the MTJ array; and
a read device electrically connected to the MTJ array and configured to read the logical state of the MTJ array as the capacitive net discharges to a second voltage different than the first voltage.

2. The memory device of claim 1, wherein
the first set of one or more MTJs having a first resistance; and
the second set of one or more MTJs having a second resistance different than the first resistance, and
wherein the capacitive net discharges a current differentially through the first set of one or more MTJs and the second set of one or more MTJs as the capacitive net discharges to the second voltage.

3. The memory device of claim 1 or 2, wherein the first set of one or more MTJs are electrically connected in series, in parallel, or in series and in parallel with one another.

4. The memory device of one of the preceding claims, wherein the second set of one or more MTJs are electrically connected in series, in parallel, or in series and in parallel with one another.

5. The memory device of one of the preceding claims, wherein the read device includes an inverter and/or a latch.

6. The memory device of one of the preceding claims, further including a delay circuit configured to generate a delay signal that temporally alters a read signal provided to the MTJ array.

7. A memory device, comprising:
a read device including an inverter and a capacitor;
a magnetic tunnel junction (MTJ) array including:
a first set of one or more MTJs with a first resistance; and
a second set of one or more MTJs with a second resistance, wherein the first resistance is different than the second resistance,
wherein the read device is capacitively connected to the MTJ array, and the read device is configured to read a state of the MTJ array after a voltage across the MTJ array is reversed.

8. The memory device of claim 7, wherein the capacitor electrically couples the MTJ array to the inverter, and the capacitor changes a switch direction of the inverter.

9. The memory device of claim 7 or 8, wherein the first set of one or more MTJs are electrically connected in series, in parallel, or in series and in parallel with one another, and/or wherein the second set of one or more MTJs are electrically connected in series, in parallel, or in series and in parallel with one another,
in particular wherein the first set of one or more MTJs and the second set of one or more MTJs include substantially similar topologies.

10. The memory device of one of claims 7 to 9, wherein the voltage across the MTJ array is dependent on a direction of the voltage across the MTJ array, wherein the first resistance is less than the second resistance or the first resistance is greater than the second resistance.

11. The memory device of one of claims 7 to 10, wherein the inverter is configured to assert a store signal creating a reinforcing logical feedback to remove the voltage across the MTJ array.

12. A method of reading a magnetic tunnel junction (MTJ) device, comprising:
during a first phase:
applying a first voltage having a first polarity to an MTJ network capacitively coupled to an inverter of a reading device, wherein the MTJ network includes a first set of one or more MTJs and a second set of one or more MTJs; and
during a second phase:
reading a logical state of the MTJ network by initiating the inverter in response to a change in the voltage of the MTJ network by applying a second voltage having a second polarity opposite the first polarity to the MTJ network.

13. The method of claim 12, wherein the first set of one or more MTJs includes a first resistance electrically coupled to a second set of one or more MTJs including a second resistance different from the first resistance.

14. The method of claim 12 or 13, wherein the first set of one or more MTJs are electrically connected in series, in parallel, or a combination thereof, and/or wherein the second set of one or more MTJs are electrically connected in series, in parallel, or in series and in parallel with one another.

15. The method of one of claims 12 to 14, wherein the inverter is configured to assert a store signal creating a reinforcing logical feedback to remove the first voltage and the second voltage across the MTJ network.
